(19) Europäisches Patentamt
European Patent Office
Office européen des brevets

(11) Publication number: **0 518 453 A1**

# (12) EUROPEAN PATENT APPLICATION

(21) Application number: **92250135.8**

(51) Int. Cl.$^5$: **G03F 7/004**, G03F 7/16

(22) Date of filing: **31.05.92**

(30) Priority: **12.06.91 US 713950**

(43) Date of publication of application:
**16.12.92 Bulletin 92/51**

(84) Designated Contracting States:
**DE FR GB IT**

(71) Applicant: **W.R. Grace & Co.-Conn.**
**Grace Plaza, 1114 Ave. of the Americas**
**New York New York 10036(US)**

(72) Inventor: **Becknell, Alan Frederick**
**8114 Aspenwood Way**
**Jessup, MD 20794(US)**
Inventor: **Hallock, John Scott**
**10324 Kingsbridge**
**Ellicott City, MD 21043(US)**
Inventor: **Elzufon, Betsy**
**9416 Fitzharding Lane**
**Owings Mills, MD 21117(US)**

(74) Representative: **UEXKÜLL & STOLBERG**
**Patentanwälte**
**Beselerstrasse 4**
**W-2000 Hamburg 52(DE)**

## (54) A method of making electrical circuit traces.

(57) A method for making electrical circuit traces is disclosed. The method comprises applying a photosensitive layer onto a metal surface by immersing the surface in an autodeposition emulsion and then processing the resulting coated surface to plate up circuit traces. The autodeposition emulsion comprises (i) resin, (ii) photoactive functionality, (iii) acid, (iv) oxidizing agent and (v) surfactant.

EP 0 518 453 A1

## Field of the Invention

The invention relates generally to methods of making electrical circuit traces for electronic circuit boards, and particularly to those methods which employ plating techniques.

## Background of the Invention

Plating methods for making circuit traces on circuit boards are well known in the art. These methods derive their name from the fact that the boards' circuit traces are "built up" or "plated up" from their metal surfaces, typically copper. Specifically, in a method which employs negative acting photoresists, processing steps include (1) applying a negative acting photosensitive protective coating onto the metal surface of the circuit board, (2) selectively exposing that coating to radiation in an image-wise fashion, e.g. through a positive phototool having the desired trace pattern, (3) immersing the coated surface in a mildly basic developing solution to remove the areas of the coating which were not exposed to radiation, thereby exposing a positive image of the desired trace pattern on the coated metal, and (4) immersing the surface in an acidic metal electroplating bath to plate up additional metal onto the exposed surfaces. The method then further comprises (5) optionally protecting the plated up traces, and (6) then stripping the remaining photocured coating and (7) etching away the metal underneath the stripped coating, thereby leaving the plated up traces as the desired circuit pattern.

As is well known, it is important to only plate up the areas of the metal surface intended for the circuit traces, i.e. the areas of metal uncovered in (3) above. Otherwise, after the etching step in (7) above, conductive copper will still remain in unwanted areas. In certain instances past plating methods have not been satisfactory in this respect, especially when preparing circuit boards having "tooling holes". These tooling holes provide a manipulation means for the automated equipment typically used to manipulate the boards during their manufacture. To facilitate this process, these holes are designed to fit snugly with the processing equipment. Any buildup of metal which reduces the effective diameter of these holes so that the equipment no longer fits will detrimentally affect this process.

For instance, past plating methods have applied the photosensitive coating by dry film lamination. See Example 1 of U. S. Patent 4,239,849. In such methods, proper photoimaging of the circuit requires that the dry film be less than 3 mils thick. Because of their thinness, these films tend to be weak and thus are subject to tearing, breaks or "pinholes". Once those flaws form, plating solution can seep through and come in contact with the tooling holes, thus depositing unwanted copper. The same problem occurs when the dry film is laid down improperly, thus allowing plating solutions to leak underneath the film and deposit copper in areas not intended for the circuit traces.

Dry film lamination incurs other problems as well. For instance, it is difficult to laminate a dry film on a surface having irregular surface features. Such features such as scratches or gouges introduced by routine manipulation, e.g. handling, cleaning, etc. frequently appear on circuit boards. In addition, these films are prepared with support sheets which not only add to the cost of the film, but also require an extra processing step to remove the support sheet before the film is used. Even further, the films are sold to the end user at a certain thickness and thus requires the user to stock films of various thicknesses for those instances where a thinner or thicker film is desired. Finally, it has been difficult to automate processes using dry film laminates because excess film has to be cut, thereby requiring awkward cutting procedures.

One method that avoids the above problems with dry film lamination is electrodeposition of the photosensitive coating. For instance, a photoresist coating is applied to the substrate by applying an electrical charge to the substrate, which in turn attracts a charged photoresist. See U. S. Patents 4,877,818 and 4,592,816 to Emmons et al. Thus, in electrodeposition a thin film of resist forms directly onto the surfaces of the tooling holes and thus allows the user to obtain a more effective coating of the hole, allows the user to vary the coating thickness as desired (up to a point), and is fairly easy to automate. However, electrodeposition also has its flaws.

For instance, electrodeposition involves additional equipment and time. Electrodeposition also consumes electrical power and requires charged resins. Even further, photoresist compositions usually have optimal component ratios at which the components should be applied to the surface. However, by using electrodeposition, preferential deposition of certain charged particles may alter the ratio of components actually deposited. Even further, electrodeposition has a limit as to the thickness of the coating which it can deposit, i.e. about 1 mil. Thus, a method which has the advantages of electrodeposition baths in that the substrate can be effectively coated and protected, but which also avoids the problems encountered when using electrodeposition methods would be desirable.

## Summary of the Invention

Thus, the general object of the invention is to provide a plating method for making circuit traces which is simple, yet avoids the problems of past plating methods.

Another object of the invention is to provide a method which effectively coats and selectively protects the circuit board's metallic surfaces by inducing the deposition of a protective coating on the surfaces by simply immersing the surface in an emulsion and then selectively processing the coating so that only certain portions of the surface are plated up.

The above objects are obtained by a method which comprises

(a) immersing the surface in an emulsion comprising

(i) resin,
(ii) photoactive functionality,
(iii) acid,
(iv) oxidizing agent, and
(v) surfactant,

wherein (i)-(v) are present in amounts and the surface is immersed for a period of time sufficient to induce a coating of resin (i) and functionality (ii) on said metallic surface;

(b) exposing said coating of resin (i) and functionality (ii) to actinic radiation in an image-wise fashion;

(c) immersing said exposed coated surface from (b) above in a developer to develop an image on said surface;

(d) immersing the developed surface from (c) in at least one plating bath to plate up the metallic surfaces which were uncovered during step (c);

(e) stripping any remaining coating in a solvent; and

(f) removing the metallic surfaces uncovered in (e).

## Detailed Description

As indicated above, the plating method of this invention applies a protective coating by immersing the metal surface of a circuit board in an emulsion which can be defined as an autodeposition bath. These types of baths have been described in the art and are termed as such because they deposit a coating on a metal surface by physical contact, e.g. immersion. They do not require the metal surface or the coating components in the bath to be electrically charged. See U.S. Patents 4,103,049 and 4,347,172 to Nishida et al. and U.S. Patent 4,366,195 to Hall.

Briefly, autodeposition baths are water-based emulsions comprising resin, a surfactant and a combination of an acid and an oxidizing agent. All of those components are present in amounts sufficient to induce the resin to coat a metal surface when immersed in the bath. Further, such baths deposit coatings in such a manner that the coating grows in thickness with time. The art has described using such baths to coat steel, aluminum, zinc and some copper surfaces.

Contrary to previous autodeposition emulsions in the art, the emulsion described herein contains photoactive functionality and is used to deposit a coating which can selectively protect the metal surfaces which are being processed for electrical circuit traces. As described above, the emulsion used in this invention comprises

(i) resin,
(ii) photoactive functionality,
(iii) acid,
(iv) oxidizing agent, and
(v) surfactant.

Resins which are suitable for the emulsion include, but are not limited to, acid containing polymers or copolymers of one of the following monomers: styrene, butadiene, isoprene, vinylidene chloride, methyl acrylate, ethyl acrylate, butyl acrylate, methyl methacrylate, ethyl methacrylate, butyl methacrylate, acrylonitrile, acrylic acid, itaconic acid, methacrylic acid, vinyl alcohol, maleic anhydride and vinyl acetate. Specific copolymers include

butadiene/acrylonitrile/methacrylic acid
styrene/acrylic acid
styrene/butadiene/acrylic acid
styrene/butadiene/methacrylic acid
styrene/butadiene/itaconic acid
styrene/butadiene/maleic acid

styrene/butadiene/butylacrylate/acrylic acid
styrene/butadiene/butylacrylate/methacrylic acid
styrene/butadiene/butylacrylate/itaconic acid
styrene/butadiene/butylacrylate/maleic acid
styrene/ethyl acrylate/methacrylic acid
styrene/maleic anhydride
styrene methacrylic acid, and
vinylidene chloride/methacrylic acid.

Resins comprising acid copolymers which have been partially modified by compounds such as simple alkyl alcohols, e.g. acid resins esterfied with butanol, may also be used. Commercially available resins include JONCRYL® 67 styrene/acrylic acid copolymer from Johnson Wax, SCRIPSET® 550 from Monsanto and SMA 17352 from Sartomer, both styrene/maleic anhydride copolymers partially esterfied with simple alkyl alcohols.

Other suitable resins include novolak resins derived from an aldehyde, such as formaldehyde, and a phenolic compound, such as phenol or cresol. Suitable examples include HT 9690, from Ciba-Geigy and HRJ 10805 from Schenectady, both cresol novolaks.

The photoactive functionalities suitable for the emulsion are those functionalities or compounds which are positive or negative acting. As is well known in the art, a positive acting functionality is a functionality or compound which becomes soluble in a developer solution when exposed to actinic radiation. A negative acting functionality, which is the preferred functionality, is a functionality or compound which polymerizes, and becomes less soluble, when exposed to radiation. As discussed later below, the photoactive functionality can be a functionality or compound separate from the resin, or the functionality can be attached to the resin, e.g. a copolymer product from an additional monomer.

Suitable positive acting photoactive functionalities include, but are not limited to, oxymethylene based monomers, o-nitrocarbinol esters, o-nitrophenyl acetals and polyesters and end-capped derivatives thereof, and benzo- and naphthoquinone diazide sulphonic esters. See U.S. Patent 4,632,900 to Demmer et al. A preferred positive acting functionality is a 4- or 5- sulfonic acid derivative of an orthodiazonaphthoquinone, e.g. a 2-diazo-1-naphthoquinone sulfonate ester. An especially preferred functionality is the 2-diazo-1-naphthoquinone-5-sulfonate triester of 2,3,4-trihydroxybenzophenone. A commercially available adduct is that known as THBP 215 Diazoester from International Photochemicals.

Another preferred positive acting functionality is o-nitrocarbinol ester. This monomer may be polymerized as a homopolymer to form the functionality or, as in one embodiment of the invention, preferably polymerized as part of a copolymer with an unsaturated acid and the same or a different ester. Such copolymers are formed using standard emulsion polymerization techniques described later below. If a nitrocarbinol is used, suitable copolymers therefrom should have a molecular weight of at least 500 and contain in the molecule at least 5% by weight, by reference to the molecular weight, of aromatic carbocyclic or heterocyclic o-nitrocarbinol ester groups of the formula

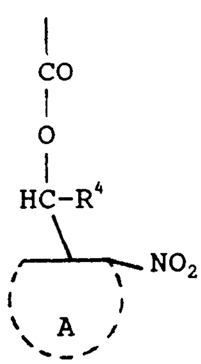

where A denotes an aromatic carbocyclic or heterocyclic ring that may be substituted and has 5 to 14 members, and $R^4$ denotes a hydrogen atom, an alkyl group of from 1 to 8 carbon atoms, or an optionally substituted aryl or aralkyl group, the optional substituents on the groups A and $R^4$ being alkyl or alkoxy groups of from 1 to 8 carbon atoms, halogen atoms, nitro, amino, or carboxylic acid groups.

Suitable ring systems A may be mononuclear or polynuclear, such as benzene, naphthalene, anthracene, anthraquinone, phenanthrene, or pyridine rings.

Examples of suitable aromatic o-nitrocarbinols upon which these o-nitrocarbinol ester groups are based

include o-nitrobenzyl alcohol, 2-nitroveratryl alcohol, 6-nitroveratryl alcohol, 2-nitro-4-aminobenzyl alcohol, 2-nitro-4-dimethylaminobenzyl alcohol, 2-nitro-5-dimethylaminobenzyl alcohol, 2-nitro-5-aminobenzyl alcohol, 2-nitro-4,6-dimethoxybenzyl alcohol, 2,4-dinitrobenzyl alcohol, 3-methyl-2,4-dinitrobenzyl alcohol, 2-nitro-4-methylbenzyl alcohol, 2,4,6-trinitrobenzyl alcohol, 2-nitrobenzhydrol, 2,2'-dinitrobenzhydrol, 2,4-dinitrobenzhydrol, 2,2',4,4'-tetranitrobenzhydrol, 2-nitro-4-methylaminobenzyl alcohol, 2-nitro-3-hydroxymethyl naphthalene, 1-nitro-2-hydroxymethyl naphthalene, 1-nitro-2-hydroxymethylanthraquinone, 3-methoxy-4-(2-nitratoethoxy)-6-nitrobenzyl alcohol and 2-nitro-3-hydroxymethyl pyridine.

If desired, photosensitizers such as aromatic ketones and thioxanthones may be included with the positive acting functionalities.

Suitable negative acting photoactive functionalities include, but are not limited to, a variety of photoprepolymers. Generically those prepolymers include, but are not limited to acrylates. More specifically, they include acrylic and methacrylic acid esters of mono-, di-, and polyhydric alcohols; and mono-, di-, and polyalkoxy acrylate and methacrylate.

Also suitable are mono-, di-, and poly- acrylates or methacrylates which are derivatized from the reaction of hydroxyl terminated acrylate or methacrylate esters with mono-, di-, and polyisocyanates, epoxides, and other hydroxy reactive compounds. Specific examples include:

ethylene glycol diacrylate
ethylene glycol dimethacrylate
propylene glycol diacrylate
propylene glycol dimethacrylate
trimethylolpropane triacrylate
trimethylolpropane ethoxylate triacrylate
trimethylolpropane propoxylate triacrylate
trimethylolpropane ethoxylate trimethacrylate
trimethylolpropane propoxylate trimethacrylate
bisphenol A diacrylate
bisphenol A ethoxylate diacrylate
phenoxyethyl methacrylate
hexanediol diacrylate
neopentyl glycol diacrylate
neopentyl propoxylate diacrylate
pentaerythritol triacrylate
dipentaerythritol hydroxypentaacrylate
polyethylene glycol diacrylate

Trimethylolpropane ethoxylate triacrylate is available as PHOTOMER® 4149 and 4155 from Henkel Corporation. Trimethylolpropane propoxylate triacrylate is available as PHOTOMER 4072 from Henkel. Other suitable negative acting prepolymers include those known as SARTOMER® 349, 454, 205, and 399 from Sartomer Co. SARTOMER® C2000 prepolymer which is a linear alkane diol diacrylate wherein the alkane has fourteen to sixteen carbons, i.e. $C_{14}$-$C_{16}$, is also suitable. Trimethylolpropane propoxylate triacrylate is preferable for its film forming properties. Coatings prepared therefrom can be developed more easily and with milder developing solutions.

When using the negative acting functionalities described above, it is necessary to use a photoinitiator. Thus hereinafter, unless described otherwise, when the term "photoactive functionality" is specifically used in regards to a negative acting functionality, the term "photoactive functionality" also includes a photoinitiator. Suitable photoinitiators for initiating polymerization of the negative acting photoprepolymers include, but are not limited to, benzoin ethers, benzil ketones, and phenones and phenone derivatives. Examples are:

acetophenone
9,10-anthraquinone
benzil
benzil dimethyl ketal
benzoin
benzoin tetrahydropyranyl ether
benzoin isobutyl ether
benzophenone
benzoyl cyclobutanone
4,4'-bis(dimethylamino)benzophenone
bis(pentaflurophenyl)titanocene
dibenzosuberone

dioctyl acetone
diethoxy acetophenone
methyl ethyl ketone
methyl isobutyl ketone
Michler's ketone
thioxanthone
xanthone

A commercially available photoinitiator used in the Examples below is Irgacure® 651 photoinitiator from Ciba-Geigy.

As mentioned above, resin (i) and the photoactive functionality (ii) may be chemically separate components in the bath or they may be chemically bound. As also mentioned above, an embodiment in which (i) and (ii) are bound can be prepared by emulsion polymerizing a monomer containing the photoactive functionality with another monomer to produce a resin having the photoactive functionality attached thereto, e.g. the nitrocarbinol ester copolymer.

Emulsion polymerization techniques, conditions and polymerization initiators are those well known in the art. Known techniques for the addition of monomers in emulsion polymerization techniques include continuous addition or sequential addition of monomer in separate portions. Known surfactants suitable for emulsifying the monomers in aqueous solution include, but are not limited to, 2,4,7,9-tetramethyl-5-decyn-4,7-diol, 3,5-dimethyl-1-hexyn-3-ol, glycerol monostearate, dipropylene glycol monostearate, dipropylene glycol monolaurate, dipropylene glycol monooleate, pentaerythritol monooleate, sodium dioctyl sulfosuccinate, sorbitan monolaurate, sodium lauryl ether sulfate, potassium xylene sulfonate, sodium cumene sulfonate, ethylene glycol monostearate, glycerol, nonyl phenol ethoxylate, polyoxyethylene cetyl ether, N-octadecyl sulfosuccinamate, polypropylene glycol monostearate, 3,6-dimethyl-4-octyn-3,6-diol, dodecyl benzene sodium sulfonate, and sodium lauryl sulfate. When emulsion polymerization is used to prepare a bath, the surfactant used in the polymerization reaction may also serve as surfactant (v) of the emulsion.

Suitable polymerization initiators include free radical generators such as peroxy disulfates- and persulfate-iron-bisulfate or metabisulfate systems. Detailed techniques, methods and conditions for emulsion polymerization are described in F. W. Billmeyer, Textbook of Polymer Science (Wiley-Interscience, New York; 2ed 1971); K. Bovey, et al., Emulsion Polymerization, (Interscience Publishers, Inc.; New York 1955); and G. M. Dekker, Kinetics and Mechanisms of Polymerization, Vol. 1 (Ed. by G.E. Ham 1969).

In a preferred embodiment of this invention, the emulsion used is that in which resin (i) is not already prepared in emulsion form. In other words, the emulsion can be prepared by direct emulsification of (i) and (ii), wherein the result is that (i) and (ii) are chemically separate components. In some instances of this embodiment, standard emulsion techniques can be used. See U. S. 4,177,177 to Vanderhoff and Kirk-Othmer Encyclopedia of Chemical Technology, 3rd edition, Volume 8, "Emulsions - Preparation", pp. 919-923. In other instances certain resins and photoactive functionalities may require other emulsion techniques. For instance one preferable technique is a combination of phase inversion and comminution techniques. Specifically, at room temperature, a water-in-oil (w/o) emulsion is formed by preparing resin (i) and photoactive functionality (ii) in solution by mixing (i) and (ii) into organic solvents such as ethyl acetate and then adding to that solution a lesser amount of water, e.g. about fifty percent by weight of the solution. The resulting w/o emulsion is then inverted into an oil-in-water (o/w) emulsion by addition of well known surfactants such as sodium alkyl benzene sulfonates, sodium alkyl sulfates or alky phenol ethoxylates in aqueous solution. In some instances, subsequent additions of surfactants may be needed to complete the inversion. To stabilize the resulting emulsion, the emulsion is comminuted by well known homogenizer or, preferably, ultrasound techniques. Any of the resins described above can be used in this technique.

Another method according to this invention employs an emulsion in which resin (i) is prepared in emulsion form. Specifically, a resin latex can be prepared by the standard emulsion polymerization techniques described above for the above-mentioned resins. The resulting latex contains resin particles which would constitute resin (i) of the emulsion.

Commercially available latices include Darex® 528L from the Organic Chemicals Division of W. R. Grace & Co.-Conn. Acrysol® ASE-75 from Rohm & Haas is also suitable.

When using latices, a surfactant from the group described earlier may be used to emulsify components (i) and (ii) in order to assist the deposition process. A commercially available surfactant is SURFYNOL® TG surfactant from Air Products, Inc.

When using any of the above-described methods for preparing the emulsion, the amounts of (i) and (ii) should be sufficient so that the total solids content of the emulsion is in the range of about 1 to 20% by weight.

After the emulsion of (i) and (ii) is formed, acid (iii) and oxidizing agent (iv) are then added to the

emulsion. The acid and oxidizing agent include those known in the art of autodeposition. It is thought that the acid and oxidizing agent cause metal from metallic surfaces to dissolve, thus creating metal ions. Those metal ions are believed to destabilize the emulsion near the metallic surface and cause the resin particles in the emulsion to deposit thereon. See U.S. Patent 4,177,180 to Hall. Examples of acids include hydrochloric, hydrofluoric, phosphoric, citric, sulfuric and acetic acids. An example of an oxidizing agent is hydrogen peroxide. The acid should be added in amounts so that the pH of the resulting emulsions is generally in the range of 1-5 and preferably in the range of 1.7-3. In some instances, metal halides such as cupric chloride and ferric chloride can also be used as oxidizing agents. In certain autodeposition baths, it may also be desirable to include a metal salt, such as a metal halide, in the bath even when another oxidizing agent is already included, e.g. $H_2O_2$. For instance, in certain latex-based emulsions, $CuCl_2$ can be used in conjunction with $H_2O_2$. In some instances, the addition of $CuCl_2$ may help induce autodeposition.

Specific combinations of acid and oxidizing agents may depend on the particular resins and photoactive functionalities used and one combination may be more suitable than others for preparing a particular autodeposition emulsion. However, such combinations can be determined by techniques known in the art of autodeposition.

The surfactant (v) used in the autodeposition emulsion can be any of those well known in the art. They include those listed earlier in conjunction with the emulsification techniques and are preferably added in addition to those used when making the emulsions of the resin and photoactive functionality.

The amounts of the emulsion's components, other than the acid, are tabulated below.

| Emulsion Component | Percentage by Weight | |
|---|---|---|
| | Suitable | Preferred |
| resin | 0.5-18.0 | 1.8-9.0 |
| photoactive functionality | 0.1-10.0 | 0.15-8.0 |
| total surfactants | 0.5-5.0 | 1-2 |
| oxidizing agent | 0.05-5.0 | 0.1-1.0 |

Other additives can also be included in the emulsion. The additives can be included as one of the original emulsion forming components or they can be added after the emulsion has been formed, depending on the additive used. Such additives include, but are not limited to, coalescing agents, stabilizers, pigments, flow aids and adhesion promoters. Commercially available stabilizers for negative photoactive functionalities include hydroquinone, p-methoxyphenol, pyrogallol, 2,6-di-t-butyl-4-methylphenol and phenothiazine. Available flow aids include MODAFLOW® from Monsanto and LITHENE PL® from Rivertex. Available pigments and dyes include any of a wide variety, e.g. NEOPEN BLUE 808® from BASF. Suitable coalescing agents are glycol ethers and esters such as PM ACETATE® (propylene glycol monomethyl ether acetate) from Eastman Chemical Co. and BUTYL DIPROPASOL® (dipropylene glycol monobutyl ether), HEXYL CARBITOL® (hexyloxyethoxy ethanol) and UCAR® ester EEP (ethyl-3-ethoxy propionate) from Union Carbide.

To obtain a coating of (i) and (ii) on a metallic surface, standard autodeposition techniques are used. For instance, the surface is immersed in the emulsion for about 30 seconds to 15 minutes, preferably at room temperature. After the surface has been immersed for a period of time so that the desired coating thickness has been obtained, the coated surface is removed from the emulsion and preferably rinsed and dried.

Subsequently, the coated metallic surface is exposed to actinic radiation in an image-wise fashion. In instances where circuits are being made and positive active functionalities are being used for photoactive functionality (ii), the coating is exposed to radiation in an image-wise fashion such that only the coating on the metal areas to be protected from the plating bath remain unexposed. In other words, the coating on the surface areas which will be plated up are exposed to radiation. If negative acting functionalities are being used, the image-wise exposure is such that the coating on the metal areas to be protected from the plating bath are exposed to the radiation while the areas to be plated up are not exposed to radiation.

Radiation used in the present invention preferably has a wavelength of 200-600 nm. Suitable sources of actinic radiation include carbon arcs, mercury vapor arcs, fluorescent lamps with phosphors emitting ultraviolet light, argon and xenon glow lamps, tungsten lamps, and photographic flood lamps. Of these, mercury vapor arcs, fluorescent sun lamps, and metal halide lamps are most suitable. The time required for the exposure will depend upon a variety of factors which include for example, the individual photoactive groups used in the emulsion, the proportion of these groups in the emulsion, the type of light source, and

its distance from the composition. Suitable times may be readily determined by those familiar with photoimaging techniques.

The developer used in the present process is selected according to the nature of the resin and photoactive functionality and photolysis products and may be an aqueous or aqueous organic solution of a base; or an organic solvent or mixture of solvents. The use of a base to form a salt, and hence solubilize the fractions of photoactive functionality or resin remaining in the areas of coating which are to be removed after irradiation, is preferred. Such basic solutions are, typically, 0.25-3.0% by weight sodium or potassium hydroxide or carbonate.

After development of the image, certain areas of the metal surface remain coated, while the other areas are uncovered. For instance, if positive acting functionalities are used, the areas of coating which are exposed to radiation are removed to uncover the metal surface to be plated up. On the other hand, when negative acting functionalities are used, the areas of coating unexposed to radiation are removed and the underlying metal surfaces are subsequently plated up.

The developed surfaces are then further processed to prepare electrical traces. As mentioned above, the next processing step taken would be to process the surface in at least one plating solution and sometimes two or more in order to obtain the desired plating thickness. Plating solutions that may be used to plate up the metal surfaces after development are known in the art and may be varied according to the nature of the metal surface.

When using copper surfaces, well known copper plating solutions can be used. They include cyanide copper, pyrophosphate copper, and acid copper sulfate solutions. Acid copper sulfate baths are generally preferred. The plating solutions are prepared and used according to conventional techniques. See Printed Circuit Handbook, C. F. Coombs, Jr. and Carano, Michael, "Copper Plating" 1985 Products Finishing Directory Trade Publication from Metal Products Finishing Industry (1984).

For instance, a preferred acid copper sulfate bath comprises the following amounts of components

| | |
|---|---|
| 60-140 g/l | copper sulfate |
| 150-260 g/l | sulfuric acid |
| 30-110 ppm | chloride ion |

and are heated to 20 - 50° C during plating. The bath is typically agitated at ambient temperature with an air sparge and operated using an anode to cathode area ratio in the range of 2-3:1. Typically, the surface is immersed in the plating solution for 30 - 60 minutes and a current of 2-5 amp/$m^2$ applied.

Prior to immersing the surface in the plating solution, the exposed areas of the metal are preferably preconditioned using conventional heated, e.g. 20 - 70° C, acid-based soap solutions, microetch baths and sulfuric acid dips. The contents of these solutions/baths and the methods of using them are well known in the art, all of which are illustrated in the Examples. These process steps are to condition the exposed metal surface for the acidic environment of the plating solution, e.g. less than 1 pH, and to rinse away any residual organics, i.e. degreasing. Residence times in these solution/baths range from about ten seconds to several minutes, e.g. four minutes.

After the exposed metal surfaces are plated up, conventional fluoboric acid and tin/lead post-plating steps are performed. The fluoboric acid conditions the plated copper for the tin/lead fluoborate bath environment and the tin/lead fluoborate bath deposits a protective layer on the plated copper to act as an etch resist in the next process step. The residence times in these baths are in the range of 1 to 10 minutes.

When using copper surfaces, the metal surface can be part of a copper laminate wherein a copper layer has been laminated onto a reinforcing layer. Suitable reinforcing layers include paper, epoxy, glass reinforced epoxy, polyimide, polytetrafluormethylene and the like.

After preconditioning, plating and post-plating steps, the coating which remains is processed for removal. If a positive resist is used, the coating is exposed to actinic radiation to render the coating soluble and then removed using a stripping solution, usually aqueous NaOH. If a negative acting resist is used, the coating is generally removed by a warm (135° F) spray of 3-5% by weight aqueous sodium hydroxide. The exposed unplated metal surface in either case is then etched away in typical etching solutions. These include basic aqueous ammonium hydroxide/cupric chloride solutions which will etch copper but not tin/lead. If desired, the tin/lead coating may be removed via acid etching, but it is often allowed to remain on the circuit as a protective solder coating.

As mentioned above, using the autodeposition emulsion method is useful in plating up two sided circuit boards which have tooling holes. These emulsions provide protection equal to that obtained by electrodeposition, but is more advantageous in that emf inducing equipment is not needed nor is there a need

for an additional process step of connecting the metallic surface to an electrical current. Moreover, resin (i) and functionality (ii) do not need to be processed to contain a charge, nor is there the preferential deposition which results from electrodepositing such charged particles.

Further, in plating circuit traces on boards having through holes, the negative acting system is sometimes preferable to a positive acting system because the through holes are easier to process using negative resists.

Even further, as the following Examples illustrate, the method of this invention provides a means for applying coatings capable of being used under standard plating conditions. The coatings resulting from the autodeposited coatings described herein are base soluble, have sufficient thickness to plate up 1-2 mil (25-50 microns) of copper without overplating, are acid resistant, have sufficient adhesion to withstand delamination resulting from electrical bias, and create minimal organic contamination.

In order to further illustrate the practice of the present invention and the advantages thereof, the following examples are provided. However, these examples are in no way meant to be limitative, but merely illustrative.

Example 1

A solution of a negative photoresist formulation was prepared with the following components:

| | |
|---|---|
| 30.1 g | JONCRYL® 67 styrene/acrylic acid copolymer from Johnson Wax |
| 10.75 g | PHOTOMER® 4072 trimethylolpropane propoxylate triacrylate from Henkel |
| 2.15 g | IRGACURE® 651 photoinitiator from Ciba-Geigy |
| 57.0 g | ethyl acetate |

To the above solution was added 0.3 g TRITON® X-100 surfactant followed by 50 g water, dropwise with mechanical stirring. A mixture of 0.9 g Stepan's POLYSTEP® A16-22 surfactant in 70 g water was added dropwise and the crude emulsion was sonicated for 2 minutes with a Sonics & Materials 500W disrupter using a 3/4" high gain Q horn at an estimated 180W intensity level. The emulsion was then concentrated on a rotary evaporator.

A deposition bath was prepared by diluting the emulsion with water, acidifying to pH 2.2 with phosphoric acid, and adding an amount of hydrogen peroxide equal to 1% of the total bath weight, where the final bath contained 10% solids. Immersion of a copper foil/epoxy glass laminate strip in the bath for 2 minutes caused deposition of about 2.0 mil of coating which was dried and coalesced for 5 minutes at 80°C. The coating was imagewise exposed to UV light for 3 minutes in a DMVL-HP contact printer from Colight with 1 kW lamps and then developed in a 1% $Na_2CO_3$ spray.

The autodeposited and imaged panel was subjected to the following preconditioning, plating and post-plating processes. Specifically, the panel was precleaned in a heated ENPLATE® PC455 sulfuric acid-based soap solution from Enthone, Inc. for 90 seconds, followed by immersion in a room temperature sulfuric acid/sodium persulfate microetch solution for 20 seconds and a sulfuric acid dip for 60 seconds. The panel was electroplated for 10 minutes in a standard acid copper sulfate bath followed by two minutes in a tin/lead fluoborate bath. Current densities were in the range 2 - 5 amps/$m^2$. Good chemical resistance was observed. In addition, good adhesion was seen between the electrodeposited metal and the copper/epoxy-glass laminate.

Example 2

A solution of a negative photoresist formulation was prepared with the following components:

| | |
|---|---|
| 30.1 g | JONCRYL® 67 copolymer |
| 10.75 g | SARTOMER® 349 bisphenol A ethoxylate diacrylate from Sartomer |
| 2.15 g | IRGACURE® 651 photoinitiator from Ciba-Geigy |
| 57.0 g | ethyl acetate |

To the above solution was added 0.3 g TRITON® X-100 surfactant followed by 50 g water, dropwise with mechanical stirring. A mixture of 0.9 g Stepan's POLYSTEP A16-22 surfactant in 70 g water was added dropwise and the crude emulsion was sonicated for 2 minutes with a Sonics & Materials 500W disrupter

using a 3/4" high gain Q horn at an estimated 180W intensity level. The emulsion was then concentrated on a rotary evaporator.

A deposition bath was prepared by diluting the emulsion with water, acidifying to pH 2.2 with 10% aqueous phosphoric acid, and adding an amount of hydrogen peroxide equal to 1% of the total bath weight. Immersion of a copper foil/epoxy glass laminate strip in the bath for 2 minutes caused deposition of about 2.3 mil of coating which was dried and coalesced for 5 minutes at 80° C. The coating was imagewise exposed to UV light for 3 minutes in a DMVL-HP contact printer from Colight with 1 kW lamps and then developed in a 1% $Na_2CO_3$ spray.

The autodeposited and imaged panel was subjected to the preconditioning, plating, and post-plating processes described in Example 1, except that tin/lead was not plated onto the plated up traces. Good chemical resistance and copper to copper adhesion were seen.

Example 3

A solution of a negative photoresist formulation was prepared with the following components:

| | |
|---|---|
| 30.1 g | JONCRYL® 67 copolymer |
| 10.75 g | SARTOMER® C 2000 $C_{14}$-$C_{16}$ alkane diol diacrylate from Henkel |
| 2.15 g | IRGACURE® 651 photoinitiator |
| 57.0 g | ethyl acetate |

To the above solution was added 0.3 g TRITON® X-100 surfactant followed by 50 g water, dropwise with mechanical stirring. A mixture of 0.9 g Stepan's POLYSTEP® A16-22 surfactant in 70 g water was added dropwise and the crude emulsion was sonicated for 2 minutes with a Sonics & Materials 500W disrupter using a 3/4" high gain Q horn at an estimated 180W intensity level. The emulsion was then concentrated on a rotary evaporator.

A deposition bath was prepared by diluting the emulsion with water, acidifying to pH 2.2 with phosphoric acid, and adding an amount of hydrogen peroxide equal to 1% of the total bath weight. Immersion of a copper foil/epoxy glass laminate strip in the bath for 2 minutes caused deposition of about 2.0 mil of coating which was dried and coalesced for 5 minutes at 80° C. The coating was imagewise exposed to UV light for 3 minutes in a DMVL-HP contact printer from Colight with 1 kW lamps and then developed in a 1% $Na_2CO_3$ spray.

The autodeposited and imaged panel was subjected to the following preconditioning and plating processes. The panel was precleaned in a heated ENPLATE® PC455 sulfuric acid-based soap solution for 90 seconds, followed by immersion in a room temperature sulfuric acid/sodium persulfate microetch solution for 20 seconds and a sulfuric acid dip for 4 minutes. The panel was electroplated for 12 minutes in a standard acid copper sulfate bath. Current densities were in the range 2 - 5 amps/$m^2$. Good chemical resistance was observed. In addition, good adhesion was seen between the electrodeposited metal and the copper/epoxy-glass laminate.

Example 4

A solution of a negative photoresist formulation was prepared with the following components:

| | |
|---|---|
| 38.41 g | SMA 17352 styrene/maleic anhydride copolymer partially esterified with simple alkyl alcohols from Sartomer Co. |
| 13.72 g | SARTOMER® 454 ethoxylated trimethylol propane triacrylate |
| 2.74 g | IRGACURE® 651 photoinitiator |
| 5.49 g | diisobutyl ketone |
| 67.25 g | ethyl acetate |

To 100 g of the above solution was added 0.3 g TRITON® X-100 surfactant followed by 50 g water, dropwise with mechanical stirring. A mixture of 0.9 g Stepan's POLYSTEP® A16-22 surfactant in 70 g water was added dropwise and the crude emulsion was sonicated for 2 minutes with a Sonics & Materials 500W disruptor using a 3/4" high gain Q horn at an estimated 180W intensity level. The emulsion was then

concentrated on a rotary evaporator.

A deposition bath was prepared by diluting the emulsion to 10% solids with water, acidifying to pH 2.2 with phosphoric acid, and adding an amount of hydrogen peroxide equal to 1% of the total bath weight. Immersion of a copper foil/epoxy glass laminate strip in the bath for 120 seconds caused deposition of about 0.7 mil of coating which was dried and coalesced for 5 minutes at 80°C. The coating was imagewise exposed to UV light for 270 seconds on a DMVL-HP contact printer with 1 kW lamps, and then developed 1 minute in a 1% aqueous $Na_2CO_3$ spray followed by about 2 minutes immersion in 0.25% aqueous NaOH until the unexposed parts of the coating completely developed away.

The autodeposited and imaged panel was subjected to the following plating process. The panel was microetched in a sulfuric acid/sodium persulfate solution for 20 seconds and dipped in sulfuric acid for 60 seconds. The panel was electroplated for 14 minutes in a standard acid copper sulfate bath followed by 5 minutes in a tin/lead fluoborate bath. Current densities were in the range of 2-5 amps/$m^2$. Good chemical resistance was observed. In addition, good adhesion was seen between the electrodeposited metal and the copper/epoxy-glass laminate. The resist was easily stripped from the boards by immersion in warm 4% aqueous NaOH for 3 minutes.

In addition to the above, a 0.7 mil film of the autodeposited material was exposed for 3 minutes on the contact printer and shown to be resistant to the copper plating bath for at least 45 minutes followed by at least 10 minutes in the tin/lead plating bath.

Example 5

A solution of a positive photoresist formulation was prepared with the following components:

| | |
|---|---|
| 36.5 g | HT 9690 resin from Ciba-Geigy |
| 6.5 g | THBP-215 Diazo Ester (54% triester) from International Photochemicals |
| 4.0 g | PM ACETATE® acetate |
| 53.0 g | ethyl acetate |

To the above solution was added a mixture of 1.5 g Stepan's POLYSTEP® A16-22 surfactant in 100 g water dropwise with mechanical stirring. A solution of 0.5 g TRITON® X-100 surfactant in 20 g water was added dropwise and the crude emulsion was sonicated for 2 minutes with a Sonics & Materials 500W disruptor using a 3/4" high gain Q horn. The emulsion was then concentrated on a rotary evaporator.

A deposition bath was prepared by diluting the emulsion to 10% solids with water, acidifying to pH 2.0 with phosphoric acid, and adding an amount of hydrogen peroxide equal to 1.0% of the total bath weight. Immersion of a copper foil/epoxy glass laminate strip in the bath for 1 minute caused deposition of about 1.2 mil of coating which was dried and coalesced for 5 minutes at 80°C. The coating was imagewise exposed to UV light for 90 seconds (about 270 mJ/$cm^2$ on an EIT radiometer) and then developed by immersion in 0.5% NaOH until the exposed parts of the coating completely developed away (60 - 70 seconds).

The autodeposited and imaged panel was subjected to the following plating process. The panel was microetched in a sulfuric acid/sodium persulfate solution for 20 seconds and dipped in sulfuric acid for 60 seconds. The panel was electroplated for 16 minutes in a standard acid copper sulfate bath. Current densities were in the range of 2 - 5 amps/$m^2$. Good chemical resistance was observed. In addition, good adhesion was seen between the electrodeposited metal and the copper/epoxy-glass laminate.

While the invention has been described with preferred embodiments, it is to be understood that variations and modifications may be resorted to as will be apparent to those skilled in the art. Such variations and modifications are to be considered within the purview and the scope of the claims appended hereto.

**Claims**

**1.** A method of making electrical circuit traces from a metallic surface wherein the method comprises
   (a) immersing the surface in an emulsion comprising
      (i) resin,
      (ii) photoactive functionality,
      (iii) acid,
      (iv) oxidizing agent, and

(v) surfactant,

wherein (i)-(v) are present in amounts and the surface is immersed for a period of time sufficient to induce a coating of resin (i) and functionality (ii) on said metallic surface;

(b) exposing said coating of resin (i) and functionality (ii) to actinic radiation in an image-wise fashion;

(c) immersing said exposed coated surface from (b) above in a developer solution to develop an image on said surface;

(d) immersing the developed surface from (c) in at least one plating bath to plate up the metallic surfaces which were uncovered during step (c);

(e) stripping any remaining coating in a solvent, and

(f) removing the metallic surfaces uncovered in (e).

**2.** A method according to Claim 1 wherein the metallic surface is copper and the plating bath in (d) is a copper plating bath.

**3.** A method according to Claim 2 wherein said copper surface is a layer in a laminate comprising at least one layer of copper laminated onto a reinforcing layer.

**4.** A method according to Claim 3 wherein said laminate has tooling holes.

**5.** A method according to Claim 1 wherein the photoactive functionality (ii) is a positive acting functionality.

**6.** A method according to Claim 5 wherein the positive acting functionality is a 2-diazo-1-naphthoquinone sulfonate triester of 2,3,4-trihydroxybenzophenone and the resin is a novolak wherein the positive acting functionality and resin are emulsified together as chemically separate components.

**7.** A method according to Claim 1 wherein the photoactive functionality (ii) is a negative acting functionality and a photoinitiator.

**8.** A method according to Claim 7 wherein the negative acting functionality comprises acrylate.

**9.** A method according to Claim 7 wherein the negative acting functionality is trimethylolpropane propoxylate triacrylate and the resin is styrene/acrylic acid copolymer wherein the negative acting functionality and resin are emulsified together as chemically separate components.

**10.** A method according to Claim 7 wherein the negative acting functionality is bisphenol A ethoxylate diacrylate and the resin is styrene/acrylic acid copolymer wherein the negative acting functionality and resin are emulsified together as chemically separate components.

**11.** A method according to Claim 7 wherein the negative acting functionality is $C_{14}$-$C_{16}$ alkane diol diacrylate and the resin is styrene/acrylic acid copolymer wherein the negative acting functionality and resin are emulsified together as chemically separate components.

**12.** A method according to Claim 1 wherein the acid is a member of the group consisting of hydrochloric, hydrofluoric, phosphoric, citric, sulfuric and acetic acids.

**13.** A method according to Claim 6 wherein the acid is a member of the group consisting of hydrochloric, hydrofluoric, phosphoric, citric, sulfuric and acetic acids.

**14.** A method according to Claim 7 wherein the acid is a member of the group consisting of hydrochloric, hydrofluoric, phosphoric, citric, sulfuric and acetic acids.

**15.** A method according to Claim 1 wherein the oxidizing agent is hydrogen peroxide.

**16.** A method according to Claim 6 wherein the oxidizing agent is hydrogen peroxide.

**17.** A method according to Claim 7 wherein the oxidizing agent is hydrogen peroxide.

**18.** A method according to Claim 1 wherein said developer solution in step (c) is aqueous sodium hydroxide or sodium carbonate.

**19.** A method according to Claim 2 wherein the copper plating bath comprises copper sulfate.

European Patent Office

# EUROPEAN SEARCH REPORT

Application Number

EP 92 25 0135

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| P,X | WO-A-9 108 840 (W.R.GRACE &CO.-CONN.)<br>* claims 24-68 *<br>--- | 1-19 | G03F7/004<br>G03F7/16 |
| A | EP-A-0 387 822 (BASF AKTIENGESELLSCHAFT)<br>* claim 6 *<br>--- | 1-19 | |
| A | EP-A-0 176 356 (ROHM AND HAAS COMPANY)<br>* page 2, line 9 - page 2, line 15 *<br>--- | 1-19 | |
| A | WO-A-9 105 023 (HENKEL CORPORATION)<br>* claims *<br>----- | 1-19 | |
| | | | TECHNICAL FIELDS SEARCHED (Int. Cl.5 ) |
| | | | G03F |

The present search report has been drawn up for all claims

| Place of search | Date of completion of the search | Examiner |
|---|---|---|
| THE HAGUE | 26 AUGUST 1992 | D. Hillebrecht |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P0401)